# EUROPEAN PATENT APPLICATION

(11) **EP 4 831 974 A1**
(43) Date of publication of application: **28.10.2026**
(21) Application number: 24931331.3
(22) Date of filing: 29.03.2024
(51) Int. Cl.: G09G 3/20, G09G 3/3266

(54) **SHIFT REGISTER, DRIVING CIRCUIT, DRIVING METHOD, AND DISPLAY DEVICE**

(71) Applicant: Boe Technology Group Co., Ltd., Beijing 100015 (CN); Chengdu BOE Optoelectronics Technology Co., Ltd., Chengdu, Sichuan 611731 (CN)
(72) Inventor: QING, Haigang, Beijing 100176 (CN); HU, Ming, Beijing 100176 (CN); QIU, Haijun, Beijing 100176 (CN); ZHANG, Jingwen, Beijing 100176 (CN)
(74) Representative: AWA Sweden AB
(86) International application number: PCT/CN2024/084768
(87) International publication number: WO 2025/199937

(57) **Abstract**

The present disclosure provides a shift register, a driving circuit, a driving method and a display device, which relates to a field of display technology. The shift register includes an input circuit configured to provide a clock signal from a clock terminal to a first node under control of an input signal from an input terminal; a control circuit configured to provide a first power supply voltage of a first power supply to the first node under control of the input signal and the clock signal; and an output circuit configured to provide the first power supply voltage or a second power supply voltage of a second power supply to an output terminal as an output signal under control of a potential of the first node and the input signal.

## Description

### TECHNICAL FIELD

The present disclosure relates to a field of display technology, in particular to a shift register, a driving circuit, a driving method and a display device.

### BACKGROUND

The current shift register circuit may achieve functions of high level shifting and high level pulse width modulation, but a connection relationship of circuit components is generally complex and a space occupied is large. In addition, due to the problem of unstable pull-down capability of the shift register circuit, a voltage waveform output by each shift register in the driving circuit may be different, thereby affecting the display quality of the display screen.

### SUMMARY

In order to solve the above problems, the present disclosure provides a shift register, a driving circuit, a driving method and a display device.

According to a first aspect, the present disclosure provides a shift register. The shift register includes an input circuit configured to provide a clock signal from a clock terminal to a first node under control of an input signal from an input terminal; a control circuit configured to provide a first power supply voltage of a first power supply to the first node under control of the input signal and the clock signal; and an output circuit configured to provide the first power supply voltage or a second power supply voltage of a second power supply to an output terminal as an output signal under control of a potential of the first node and the input signal.

According to embodiments of the present disclosure, the output circuit is configured to provide the first power supply voltage or a second power supply voltage of a second power supply to an output terminal as an output signal under control of a potential of the first node and the input signal, including: providing the first power supply voltage to the output terminal as the output signal under control of the potential of the first node; and providing the second power supply voltage to the output terminal as the output signal under control of the potential of the first node and the input signal.

According to embodiments of the present disclosure, the output circuit includes a first transistor, a second transistor, a third transistor, a fourth transistor and a first capacitor. A control electrode of the first transistor is electrically connected to the first node, a first electrode of the first transistor is electrically connected to the first power supply, and a second electrode of the first transistor is electrically connected to the output terminal. A control electrode of the second transistor is electrically connected to a second node, a first electrode of the second transistor is electrically connected to the output terminal, and a second electrode of the second transistor is electrically connected to the second power supply. A control electrode of the third transistor is electrically connected to the input terminal, and a first electrode of the third transistor is electrically connected to the first node. A control electrode of the fourth transistor is electrically connected to the input terminal, a first electrode of the fourth transistor is electrically connected to the second node, and a second electrode of the fourth transistor is electrically connected to the second power supply. A first terminal of the first capacitor is electrically connected to the first power supply, and a second terminal of the first capacitor is electrically connected to the first node.

According to embodiments of the present disclosure, the first transistor and the second transistor are different types of transistors.

According to embodiments of the present disclosure, the control electrode of the second transistor includes a first control electrode and a second control electrode. The first control electrode of the second transistor is electrically connected to the second node, and the second control electrode of the second transistor is electrically connected to a third power supply. The control electrode of the fourth transistor includes a first control electrode and a second control electrode. The first control electrode of the fourth transistor is electrically connected to the input terminal, and the second control electrode of the fourth transistor is electrically connected to the third power supply. A third power supply voltage is less than the second power supply voltage.

According to embodiments of the present disclosure, the input circuit is configured to provide a clock signal from a clock terminal to a first node under control of an input signal from an input terminal, including: providing, when the clock signal switches from a first level to a second level, the second level of the clock signal to the first node, under control of a first level of the input signal.

According to embodiments of the present disclosure, the input circuit includes a fifth transistor, a sixth transistor and a second capacitor; A control electrode of the fifth transistor is electrically connected to the third node, a first electrode of the fifth transistor is electrically connected to the clock terminal, and a second electrode of the fifth transistor is electrically connected to the first node. A first terminal of the second capacitor is electrically connected to the third node, and a second terminal of the second capacitor is electrically connected to the clock terminal. A control electrode of the sixth transistor is electrically connected to the input terminal, a first electrode of the sixth transistor is electrically connected to the first power supply, and a second electrode of the sixth transistor is electrically connected to the third node.

According to embodiments of the present disclosure, the control circuit is configured to provide a first power supply voltage of a first power supply to the first node under control of the input signal and the clock signal, including: providing the first power supply voltage to the first node, under control of a second level of the clock signal and a second level of the input signal, so as to control the potential of the first node to be at a first level; and controlling the potential of the first node to maintain at a first level under control of the second level of the clock signal and a first level of the input signal.

According to embodiments of the present disclosure, the control circuit includes a seventh transistor, an eighth transistor and a third capacitor. A control electrode of the seventh transistor is electrically connected to the clock terminal, a first electrode of the seventh transistor is electrically connected to the input terminal, and a second electrode of the seventh transistor is electrically connected to a fourth node. A control electrode of the eighth transistor is electrically connected to the fourth node, a first electrode of the eighth transistor is electrically connected to the first node, and a second electrode of the eighth transistor is electrically connected to the first power supply. A first terminal of the third capacitor is electrically connected to the fourth node, and a second terminal of the third capacitor is electrically connected to the first power supply.

According to a second aspect, the present disclosure provides a driving circuit, including M cascaded shift registers. An input terminal of an m^{th} shift register is electrically connected to an output terminal of an (m-1)^{th} shift register, 1<m≤M, m is an integer, and M is an integer greater than 1.

According to embodiments of the present disclosure, the driving circuit further includes a first clock signal line and a second clock signal line. The m^{th} shift register is electrically connected to the first clock signal line, and the (m+1)^{th} shift register is electrically connected to the second clock signal line.

According to a third aspect, the present disclosure provides a display device, including the driving circuit as provided in embodiments of the present disclosure.

According to a fourth aspect, the present disclosure provides a driving method applied to any one of the shift registers provided in embodiments of the present disclosure, including: in a first stage, in which the input signal is at a first level and the clock signal is at a second level; in a second stage, in which the input signal is at the first level and the clock signal is at the first level; in a third stage, in which the input signal is at the first level and the clock signal is at the second level; in a fourth stage, in which the input signal is at the second level and the clock signal is at the first level; and a fifth stage, in which the input signal is at the second level and the clock signal is at the second level.

According to embodiments of the present disclosure, in the first stage, the second level of the clock signal is provided to the first node under control of the first level of the input signal and the second level of the clock signal; and the first power supply voltage is provided to an output terminal as an output signal under control of a potential of the first node.

According to embodiments of the present disclosure, in the second stage, a potential of the first node is controlled to maintain at the second level under control of the first level of the input signal and the first level of the clock signal; and the first power supply voltage is provided to an output terminal as an output signal under control of the potential of the first node.

According to embodiments of the present disclosure, in the third stage, the second level of the clock signal is provided to the first node under control of the first level of the input signal and the second level of the clock signal; and the first power supply voltage is provided to an output terminal as an output signal under control of a potential of the first node.

According to embodiments of the present disclosure, in the fourth stage, a potential of the first node is controlled to maintain at the second level under control of the second level of the input signal and the first level of the clock signal; and the first power supply voltage is provided to an output terminal as an output signal under control of the potential of the first node.

According to embodiments of the present disclosure, in the fifth stage, the first power supply voltage is provided to the first node under control of the second level of the input signal and the second level of the clock signal; and the second power supply voltage is provided to an output terminal as an output signal under control of a potential of the first node.

### BRIEF DESCRIPTION OF THE DRAWINGS

FIG. 1A is a schematic diagram of a structure of a shift register of an example;
FIG. 1B is a signal timing diagram of a shift register of an example;
FIG. 2 is a schematic diagram of a structure of a shift register according to an embodiment of the present disclosure;
FIG. 3 is a schematic diagram of a structure of a shift register according to another embodiment of the present disclosure;
FIG. 4A is a signal timing diagram of a shift register according to an embodiment of the present disclosure;
FIG. 4B is a simulation diagram of a voltage in a shift register according to an embodiment of the present disclosure;
FIG. 5 is a schematic diagram of a structure of a shift register according to another embodiment of the present disclosure;
FIG. 6 is a schematic diagram of a structure of a shift register according to another embodiment of the present disclosure;
FIG. 7 is a signal timing diagram of a shift register according to another embodiment of the present disclosure;
FIG. 8A is a schematic diagram of a structure of a driving circuit according to an embodiment of the present disclosure;
FIG. 8B is a signal timing diagram of a driving circuit according to an embodiment of the present disclosure;
FIG. 9 is a schematic diagram of a structure of a display device according to an embodiment of the present disclosure; and
FIG. 10 is a flowchart of a driving method according to an embodiment of the present disclosure.

### DETAILED DESCRIPTION OF EMBODIMENTS

In order to make purposes, technical solutions, and advantages of embodiments of the present disclosure clearer, technical solutions in the embodiments of the present disclosure will be described clearly and completely in combination with accompanying drawings. Apparently, the described embodiments are only part of the embodiments of the present disclosure, not all of them. Based on the embodiments of the present disclosure provided, all other embodiments obtained by those of ordinary skilled in the art without creative labor, fall within the protection scope of the present disclosure. It should be noted that throughout the drawings, same elements are represented by same or similar reference signs. In the following description, some specific embodiments are only for descriptive purposes and should not be understood as limiting the present disclosure, but rather as examples of the embodiments of the present disclosure. When it may cause confusion in understanding of the present disclosure, conventional structures or configurations will be omitted. It should be noted that a shape and size of each component in the drawings do not reflect the true size and proportion, but only represent contents of the embodiments of the present disclosure.

Unless otherwise defined, the technical or scientific terms used in the embodiments of the present disclosure shall have the usual meaning understood by those of ordinary skilled in the art. The terms "first", "second", and similar terms used in the embodiments of the present disclosure do not indicate any order, quantity, or importance, but are only used to distinguish different components.

In addition, in description of the embodiments of the present disclosure, the terms "connected" or "electrically connected to" may refer to two components being directly electrically connected to each other, or may refer to two components being connected to each other through one or more other components. In addition, these two components may be connected or coupled in a wired or wireless way.

A source and drain of a switching transistor used in embodiments of the present disclosure are symmetrical, thus the source and drain may be interchangeable. In the embodiments of the present disclosure, according to the functions, the gate may be referred to as a control electrode, one of the source and the drain may be referred to as a first electrode, and the other one of the source and the drain may be referred to as a second electrode.

Furthermore, in the description of the embodiments of the present disclosure, the terms "first power supply voltage" and "second power supply voltage" are only used to distinguish an amplitude difference between the two power supply voltages. For example, in the following text, the "first power supply voltage" is described as a relatively high voltage, and the "second power supply voltage" and "third power supply voltage" are described as relatively low voltages. Those of skill in the art may understand that the present disclosure is not limited to this.

It should be noted that in the explanation of the embodiments of the present disclosure, INPUT may represent both an input signal terminal and an input signal provided by the input signal terminal. Similarly, the symbol CK may represent both a clock terminal and a clock signal provided by the clock terminal. OUT may represent both an output signal terminal and an output signal output by the output signal terminal. VGH, VGL1 and VGL2 may represent both a power supply terminal and a power supply voltage provided by the power supply terminal. For example, the power supply VGH may provide a high level voltage, and the power supply VGL1 and the power supply VGL2 may provide low level voltages. The following embodiments are the same as these, which will not be repeated here.

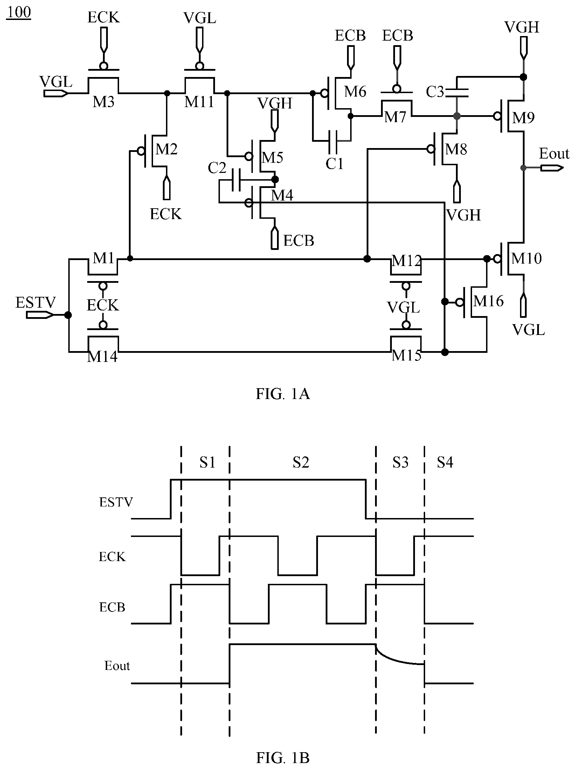

FIG. 1A is a schematic diagram of a structure of a shift register of an example. FIG. 1B is a signal timing diagram of a shift register shown in FIG. 1A.

FIG. 1A shows a shift register 100. As shown in FIG. 1A, the shift register 100 includes 16 TFT transistors and 3 capacitors.

FIG. 1B shows a timing change process of each signal of the shift register 100 in FIG. 1A.

As shown in FIG. 1A, the shift register 100 includes 16 P-type transistors and 3 capacitors.

In a first stage S1, ESTV is at a high level, ECK is at a low level, and ECB is at a high level. Under control of the low level of the ECK and the power supply voltage VGL, a high level signal of ESTV is written into a control electrode of a second transistor M2 through a turned-on first transistor M1, and then written into a control electrode of a tenth transistor M10 and a control electrode of an eighth transistor M8 through a twelfth transistor M12, so that the second transistor M2, the eighth transistor M8 and the tenth transistor M10 are turned off. The power supply voltage VGL controls a sixth transistor M6 to be turned on through a turned-on third transistor M3 and a turned-on eleventh transistor M11. A seventh transistor M7 is turned off by a high level signal of the ECB. At this time, a ninth transistor M9 maintains the state of the previous stage, and an output terminal Eout is in a floating state. At this time, the output terminal Eout maintains a low level signal output of the previous stage.

In a second stage S2, ECB becomes at a low level and ECK becomes at a high level. Under control of the low level of the ECB, the low level signal of the ECB passes through the sixth transistor M6 and the seventh transistor M7, and controls the ninth transistor M9 to be turned on, so that the output terminal Eout outputs a high level. When ECB becomes at a high level and ECK becomes at a low level, a voltage stored in a capacitor C3 keeps the ninth transistor M9 to be turned on, so that the output terminal Eout outputs a high level.

In a third stage S3, ESTV is at a low level and ECK is at a low level. Under control of the low level of the ECK and the power supply voltage VGL, the power supply voltage VGL controls the sixth transistor M6 to be turned on through the turned-on third transistor M3 and the turned-on eleventh transistor M11. The low level signal of the ESTV is written into the control electrode of the eighth transistor M8 through the turned-on first transistor M1, so that the eighth transistor M8 is turned on. The power supply voltage VGH may control the ninth transistor M9 to be turned off through the eighth transistor M8, so that the output terminal Eout outputs a low level.

In a fourth stage S4, ESTV is at a low level, ECB is at a low level, and ECK is at a high level. Under control of the high level of the ECK, the first transistor M1 and the twelfth transistor M12 are turned off, and the ESTV signal may not be written. The tenth transistor M10 and the eighth transistor M8 maintain turned-on states of the previous stage, and the power supply voltage VGH controls the ninth transistor M9 to be turned off through the eighth transistor M8, so that the output terminal Eout outputs a low level.

Since the tenth transistor M10 is a P-type transistor, the P-type transistor has a weak turned-on ability for low levels, which causes the voltage output by the output terminal Eout in the third stage S3 to slowly change from a high level to a low level, resulting in a step phenomenon in a falling edge of the output voltage Eout, as shown in FIG. 1B.

In the shift register 100, the step phenomenon of the falling edge of the output voltage Eout is affected by a TFT characteristic parameter Vth of the first transistor M1, the tenth transistor M10 and the twelfth transistor M12. Since the driving circuit includes a plurality of cascaded shift registers, there are differences between transistors in different shift registers, and step states represented by the falling edges of the output voltages Eout output by different shift registers are different. Since waveforms of the output voltages Eout output by different stages of the shift register changing from a high level to a low level are different, this may cause horizontal stripes to appear on the display screen driven by the driving circuit including the plurality of cascaded shift registers 100.

Since the step state represented by the falling edge of the output voltage Eout may cause a poor display image, it is required to eliminate the step phenomenon in the output voltage Eout, so that the falling edge of the output voltage Eout output by each shift register may quickly transition from a high level to a low level, and the waveform of the output voltage Eout output by each different stage of the shift register is the same, thereby improving the display image.

For the above problems, the present disclosure provides a shift register. A P-type TFT transistor is used as a pull-up transistor to output a high level and an N-type TFT transistor is used as a pull-down transistor to output a low level. In the output circuit, a combined circuit of P-type transistors and N-type transistors is used, which is directly controlled by the input signal and the clock signal to complete the shift output and pulse width modulation of high level signals.

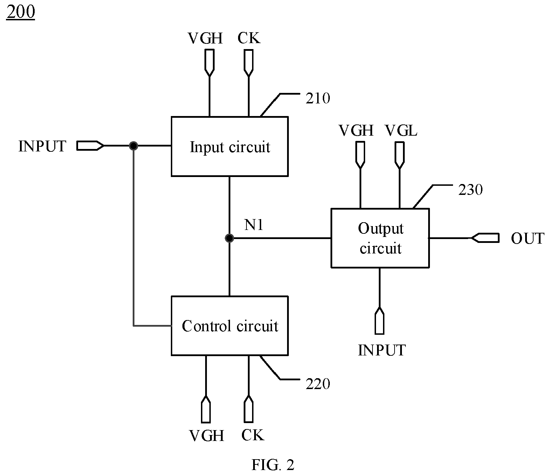

FIG. 2 is a schematic diagram of a structure of a shift register according to an embodiment of the present disclosure.

As shown in FIG. 2, a shift register 200 includes an input circuit 210, a control circuit 220 and an output circuit 230.

In an embodiment of the present disclosure, the input circuit 210 is electrically connected to a clock terminal CK, and the input circuit 210 is electrically connected to an input terminal INPUT. The control circuit 220 is electrically connected to a first power supply VGH. The control circuit 220 is electrically connected to the clock terminal CK. The control circuit 220 is electrically connected to the input terminal INPUT. The output circuit 230 is electrically connected to the input terminal INPUT. The output circuit 230 is electrically connected to the first power supply VGH. The output circuit 230 is electrically connected to a second power supply VGL1. The output circuit 230 is electrically connected to an output terminal OUT.

The input circuit 210, the control circuit 220 and the output circuit 230 are electrically connected to a first node N1.

In the embodiment of the present disclosure, the input circuit 210 is configured to provide a clock signal CK from the clock terminal CK to the first node N1 under control of an input signal INPUT from the input terminal INPUT. The control circuit 220 is configured to provide a first power supply voltage VGH of the first power supply VGH to the first node N1 under control of the input signal INPUT and the clock signal CK. The output circuit 230 is configured to provide the first power supply voltage VGH or the second power supply voltage VGL1 of the second power supply VGL1 to the output terminal OUT as an output signal OUT under control of a potential of the first node N1 and the input signal INPUT.

In the embodiment of the present disclosure, a first level may be a high level, and a second level may be a low level. When the input signal INPUT is at a high level, if the clock signal CK transitions from a high level to a low level, the input circuit 210 may provide the low level of the clock signal CK to the first node N1, but the control circuit 220 may not provide the first power supply voltage VGH to the first node N1. Under control of the clock signal CK, the input circuit 210 pulls down the potential of the first node N1, so that the output circuit 230 outputs a high level signal.

When the input signal INPUT is at a high level and the clock signal CK is at a high level, both the input circuit 210 and the control circuit 220 may not provide a voltage signal to the first node N1. At this time, the first node N1 maintains a low level state of the previous stage, and the output circuit 230 is controlled to output a high level. When the input signal INPUT is at a low level and the clock signal CK is at a high level, the input circuit 210 and the control circuit 220 still may not provide a voltage signal to the first node N1, and the first node N1 maintains the low level state of the previous stage. The output circuit 230 is controlled to output a high level signal.

The input circuit 210 is also electrically connected to the first power supply voltage VGH. When both the input signal INPUT and the clock signal CK are at low levels, the input circuit 210 may not provide the low level of the clock signal CK to the first node N1 under control of the first power supply voltage VGH. At this time, the control circuit 220 may provide the first power supply voltage VGH to the first node N1, thereby raising the potential of the first node N1, so that the output circuit 230 outputs a low level signal.

According to the embodiment of the present disclosure, through changing the potential of the first node N1 by the shift register 200 under control of the input signal INPUT and the clock signal CK, the output circuit 230 outputs a high level signal or a low level signal.

The shift register 200 completes the output of high level signals under control of the clock signal CK, and the output signal OUT may be quickly pulled down when transitioning from a high level to a low level, avoiding the phenomenon of voltage instability when the voltage of the output signal is pulled down.

According to the embodiment of the present disclosure, under control of the low level of the first node N1, the output circuit 230 provides the first power supply voltage VGH to the output terminal OUT as the output signal OUT. Under control of the high level of the first node N1 and the low level of the input signal INPUT, the second power supply voltage VGL1 is provided to the output terminal OUT as the output signal OUT.

Under control of the potential of the first node N1 and the input signal, the output circuit 230 provides the first power supply voltage VGH and the second power supply voltage VGL1 to the output terminal OUT as output signals, achieving the output of high level signals.

According to the embodiment of the present disclosure, under control of the first level of the input signal INPUT, when the clock signal CK switches from the first level to the second level, the input circuit 210 provides the second level of the clock signal CK to the first node N1.

In the embodiment of the present disclosure, when the input signal INPUT is at a high level, and the clock signal CK changes from a high level to a low level, the low level of the clock signal CK may be provided by the input circuit 210 to the first node N1, thereby pulling down the potential of the first node N1. Since the potential of the first node N1 may control the potential of the output signal OUT, the input circuit 210 may change the potential of the first node N1 under control of the input signal INPUT and the clock signal CK, thereby indirectly controlling the potential of the output signal.

According to the embodiment of the present disclosure, under control of the second level of the clock signal CK and the second level of the input signal INPUT, the control circuit 220 provides the first power supply voltage VGH to the first node N1, and controls the potential of the first node N1 to be at the first level. Under control of the second level of the clock signal CK and the first level of the input signal INPUT, the potential of the first node N1 is controlled to maintain at the second level.

In the embodiment of the present disclosure, when the clock signal CK and the input signal INPUT are at low levels, the control circuit 220 provides the first power supply voltage VGH to the first node N1, pulling up the potential of the first node N1. Since the potential of the first node N1 may control the potential of the output signal, the control circuit 220 may change the potential of the first node N1 under control of the input signal and the clock signal CK, indirectly controlling the potential of the output signal.

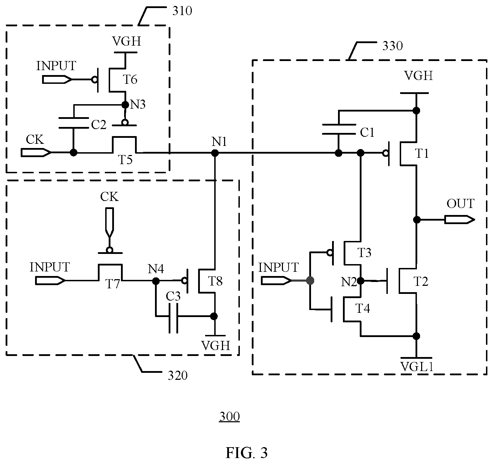

FIG. 3 is a schematic diagram of a structure of a shift register according to another embodiment of the present disclosure.

As shown in FIG. 3, a shift register 300 includes an input circuit 310, a control circuit 320 and an output circuit 330.

In the embodiment of the present disclosure, the input circuit 310, the control circuit 320, and the output circuit 330 are similar to the input circuit 210, the control circuit 220, and the output circuit 230 described above, respectively, which will not be repeated for the sake of conciseness.

In the embodiment of the present disclosure, the output circuit 330 includes a first transistor T1, a second transistor T2, a third transistor T3, a fourth transistor T4 and a first capacitor C1. The input circuit 310 includes a fifth transistor T5, a sixth transistor T6 and a second capacitor C2. The control circuit 320 includes a seventh transistor T7, an eighth transistor T8 and a third capacitor C3. The first transistor T1 and the second transistor T2 are different types of transistors. The first transistor T1, the third transistor T3, the fifth transistor T5, the sixth transistor T6, the seventh transistor T7 and the eighth transistor T8 are P-type transistors, and the second transistor T2 and the fourth transistor T4 are N-type transistors.

In the embodiment of the present disclosure, a control electrode of the first transistor T1 is electrically connected to the first node N1, a first electrode of the first transistor T1 is electrically connected to the first power supply VGH, and a second electrode of the first transistor T1 is electrically connected to the output terminal OUT.

A control electrode of the second transistor T2 is electrically connected to a second node N2, a first electrode of the second transistor T2 is electrically connected to the output terminal OUT, and a second electrode of the second transistor T2 is electrically connected to the second power supply VGL1.

A control electrode of the third transistor T3 is electrically connected to the input terminal INPUT, a first electrode of the third transistor T3 is electrically connected to the first node N1, and a second electrode of the third transistor T3 is electrically connected to the second node N2.

A control electrode of the fourth transistor T4 is electrically connected to the input terminal INPUT, a first electrode of the fourth transistor T4 is electrically connected to the second node N2, and a second electrode of the fourth transistor T4 is electrically connected to the second power supply VGL1.

A first terminal of the first capacitor C1 is electrically connected to the first power supply VGH, and a second terminal of the first capacitor C1 is electrically connected to the first node N1.

A control electrode of the sixth transistor T6 is electrically connected to the input terminal INPUT, a first electrode of the sixth transistor T6 is electrically connected to the first power supply VGH, and a second electrode of the sixth transistor T6 is electrically connected to a third node N3.

A control electrode of the fifth transistor T5 is electrically connected to the third node N3, a first electrode of the fifth transistor T5 is electrically connected to the clock terminal CK, and a second electrode of the fifth transistor T5 is electrically connected to the first node N1.

A first terminal of the second capacitor C2 is electrically connected to the third node N3, and a second terminal of the second capacitor C2 is electrically connected to the clock terminal CK.

A control electrode of the seventh transistor T7 is electrically connected to the clock terminal CK, a first electrode of the seventh transistor T7 is electrically connected to the input terminal INPUT, and a second electrode of the seventh transistor T7 is electrically connected to a fourth node N4.

A control electrode of the eighth transistor T8 is electrically connected to the fourth node N4, a first electrode of the eighth transistor T8 is electrically connected to the first node N1, and a second electrode of the eighth transistor T8 is electrically connected to the first power supply VGH.

A first terminal of the third capacitor C3 is electrically connected to the fourth node N4, and a second terminal of the third capacitor C3 is electrically connected to the first power supply VGH.

In the embodiment of the present disclosure, the type of the first transistor T1 is different from the type of the second transistor T2. The first transistor T1 is a P-type transistor used to pull up the potential of the output signal. The second transistor T2 is an N-type transistor used to pull down the potential of the output signal.

It should be noted that the N-type TFT transistor in the present disclosure may be an LTPS process transistor, an oxide process transistor, or a transistor manufactured by other processes. The present disclosure does not limit the process type of the transistor.

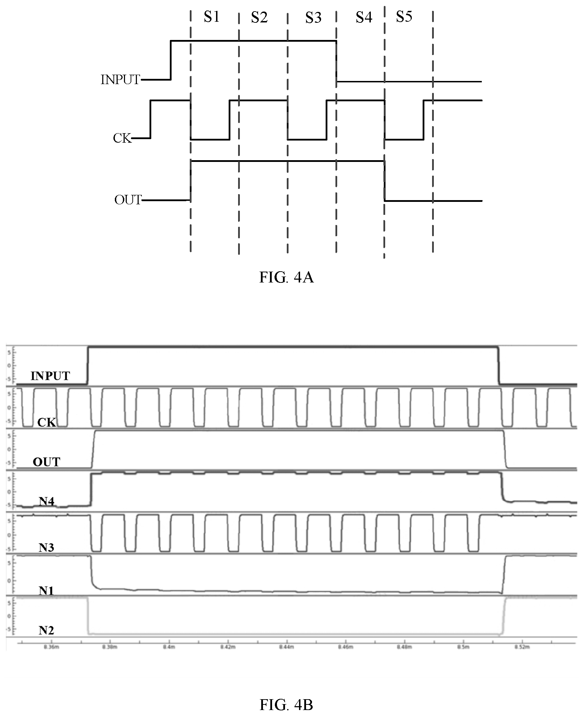

FIG. 4A is a signal timing diagram of a shift register according to an embodiment of the present disclosure.

By taking the structure of the shift register 300 shown in FIG. 3 as an example, an operation process of the shift register provided by the embodiment of the present disclosure will be described below, in combination with the signal timing diagram shown in FIG. 4A. The operation process of the shift register 300 is divided into five stages.

Before a first stage S1, the input signal INPUT is at a high level. Under control of the input signal INPUT, the fourth transistor T4 is turned on, and the third transistor T3 and the sixth transistor T6 are turned off. The second power supply voltage VGL1 is provided to the second node N2 via the fourth transistor T4, the second transistor T2 is turned off, and the output signal output by the output terminal OUT maintains at the level of the previous stage.

In the first stage S1, the input signal INPUT maintains at a high level, and the clock signal CK changes from a high level to a low level.

Since the sixth transistor T6 is turned off before the clock signal CK changes from a high level to a low level, the third node N3 is in a floating state when the clock signal CK changes from a high level to a low level. The low level of the clock signal CK is coupled to the third node N3 through the second capacitor C2, so that the third node N3 is at a low level.

Under control of the low level of the third node N3, the fifth transistor T5 is turned on, and the low level of the clock signal CK is provided to the first node N1 through the fifth transistor T5, pulling down the first node N1 to a low level.

Under control of the low level of the clock signal CK, the seventh transistor T7 is turned on, so that the high level of the input signal INPUT is provided to the fourth node N4 through the seventh transistor T7, and the eighth transistor T8 is turned off. The input signal INPUT charges the third capacitor C3, so that the third capacitor C3 stores a high level.

The low level of the clock signal CK is stored in the first capacitor C1 after pulling down the potential of the first node N1, and at the same time the first transistor T1 is turned on. The first power supply voltage VGH is provided to the output terminal OUT through the first transistor T1, outputting a high level output signal OUT.

Under control of the high level of the input signal INPUT, the third transistor T3 is turned off, the fourth transistor T4 is turned on, and the low level of the second power supply voltage VGL1 pulls down the second node N2 through the fourth transistor T4. The second transistor T2 is turned off. The low voltage of the second power supply voltage VGL1 may not be provided to the output terminal OUT through the turned-off second transistor T2 at this time.

In a second stage S2, the input signal INPUT is at a high level, and the clock signal CK changes from a low level to a high level.

Under control of the high level of the input signal INPUT and the clock signal CK, the sixth transistor T6 and the seventh transistor T7 are turned off. The high level stored in the third capacitor C3 keeps the fourth node N4 at a high level, and the eighth transistor T8 is turned off.

In a case that the clock signal CK changes from a low level to a high level, the third node N3 is pulled up to a high level through coupling the second capacitor C2, thereby turning off the fifth transistor T5. At this time, the first node N1 maintains a low level, and states of the first transistor T1, the second transistor T2, the third transistor T3 and the fourth transistor T4 are the same as those in the first stage S1. The first transistor T1 and the fourth transistor T4 are turned on, the second transistor T2 and the third transistor T3 are turned off, and the output signal OUT output by the output terminal OUT maintains at a high level.

In a third stage S3, the input signal INPUT is at a high level, and the clock signal CK changes from a high level to a low level. The timing changes of the signals of the shift register in the third stage S3 are similar to those in the first stage S1, so the turned-on/turned-off states of the components in the circuit are similar. The first node N1 is at a low level, and the output signal OUT output by the output terminal OUT maintains at a high level.

In a fourth stage S4, the input signal INPUT is at a low level, and the clock signal CK changes from a low level to a high level.

Under control of the high level of the clock signal CK, the seventh transistor is turned off. The low level of the input signal INPUT may not be provided to the fourth node N4, the fourth node N4 maintains at a high level, and the eighth transistor T8 is turned off.

Under control of the low level of the input signal INPUT, the third transistor T3 and the sixth transistor T6 are turned on, and the fourth transistor T4 is turned off. The first power supply voltage VGH is provided to the third node N3 through the sixth transistor T6, so that the third node N3 is at a high level. Under control of the high level of the third node N3, the fifth transistor T5 is turned off. The first node N1 still maintains at a low level, and the first transistor T1 is turned on. The low level of the first node N1 is provided to the second node N2 through the third transistor T3, the second transistor T2 is turned off, and the output signal OUT output by the output terminal OUT maintains at a high level.

In a fifth stage S5, the input signal INPUT is at a low level, and the clock signal CK changes from a high level to a low level.

Under control of the low level of the input signal INPUT, the third transistor T3 and the sixth transistor T6 are turned on, and the fourth transistor T4 is turned off. The first power supply voltage VGH is provided to the third node N3 through the sixth transistor T6, so that the third node N3 is at a high level and the fifth transistor T5 is turned off, resulting in the clock signal CK not being provided to the first node N1 through the fifth transistor T5.

Under control of the low level of the clock signal CK, the seventh transistor T7 is turned on. The low level of the input signal INPUT is provided to the fourth node N4 through the seventh transistor T7, so that the eighth transistor T8 is turned on.

In a case that the eighth transistor T8 is turned on, the first power supply voltage VGH is provided to the first node N1 through the eighth transistor T8, and the potential of the first node N1 is pulled up to a high level.

Under control of the high level of the first node N1, the first transistor T1 is turned off. The high level of the first node N1 is provided to the second node N2 through the third transistor T3. The second node N2 is pulled up to a high level, the second transistor T2 which is the N-type transistor is turned on, and the second power supply voltage VGL1 is provided to the output terminal through the second transistor T2. At this time, the output signal OUT of the output terminal OUT is at a low level. Moreover, before the input signal INPUT becomes a high level, the output signal OUT of the output terminal OUT will maintain at a low level.

In such stage S5, the second transistor T2 used in the embodiment of the present disclosure is an N-type TFT transistor, which has a strong pull-down capability and is easy to pull down the voltage of the output terminal OUT to the low level of VGL1. Under an action of the second transistor T2, the voltage of the output terminal OUT may be quickly pulled down to a low level, and the potential of the output signal is more stable. In addition, the circuit connection relationship of the shift register 300 is simple, the number of transistors and capacitors is small, and the space occupied is small, which is conducive to the narrowing of the display panel frame.

FIG. 4B is a simulation diagram of a voltage in a shift register according to an embodiment of the present disclosure.

As shown in FIG. 4B, the simulation waveforms of potentials of INPUT, CK and OUT at each shift register provided by the embodiment of the present disclosure refer to the timing waveforms described in FIG. 4A, which will not be repeated for the sake of conciseness.

With reference to the structure of the shift register 300 of FIG. 3, the potential changes of the first node N1, the second node N2, the third node N3 and the fourth node N4 are described.

In a case that the input signal INPUT is at a high level, when the clock signal CK decreases from a high level to a low level, the potential of the first node N1 becomes a low level, and when the input signal INPUT maintains at a high level, the potential of the first node N1 always maintains at a low level, so that the first transistor T1 is turned on and the output terminal OUT outputs a high level.

Under control of the high level of the input signal INPUT, the third transistor T3 is turned off, and the fourth transistor T4 maintains turned on, so that the second power supply voltage VGL1 is provided to the second node N2 through the fourth transistor T4. When the input signal INPUT is at a high level, the second node N2 always maintains at a low level.

Under control of the high level of the input signal INPUT, the sixth transistor T6 is turned off, and the control electrode of the fifth transistor T5 is in a floating state. The clock signal CK is coupled to the potential of the third node N3 through the second capacitor C2, so that the change of the potential of the third node N3 is consistent with the clock signal CK.

When the input signal INPUT is at a high level and the clock signal CK changes from a high level to a low level, the seventh transistor T7 is turned on, so that the input signal INPUT is provided to the fourth node N4 through the seventh transistor T7, and the fourth node N4 is at a high level. The input signal INPUT charges the third capacitor C3, so that the third capacitor C3 stores a high level. When the clock signal CK changes from a low level to a high level, the seventh transistor T7 is turned off, and the high level stored in the third capacitor C3 keeps the potential of the fourth node N4 still maintained at a high level.

In an example, the low level of the clock signal CK provided by the present disclosure may be less than or equal to the second power supply voltage VGL1. When the low level signal of the clock signal CK is less than the second power supply voltage VGL1, the turned-on effect of the seventh transistor T7 is enhanced, which is beneficial for the level of the input signal INPUT to be written into the fourth node N4 through the seventh transistor T7, thereby enhancing the turned-on effect of the eighth transistor T8 accordingly. This is also beneficial for the first power supply voltage VGH to be written into the first node N1 through the eighth transistor T8 in the fifth stage S5, thereby ensuring that the first transistor T1 is completely turned off and improving the output effect of the shift register. It may be understood that the present disclosure does not limit a voltage relationship between the low level of the clock signal CK and the second power supply voltage VGL1.

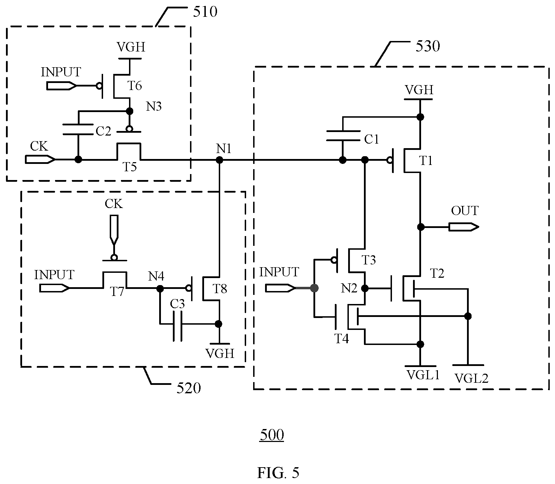

FIG. 5 is a schematic diagram of a structure of a shift register according to another embodiment of the present disclosure.

As shown in FIG. 5, a shift register 500 includes an input circuit 510, a control circuit 520 and an output circuit 530.

In the embodiment of the present disclosure, the structures of the input circuit 510 and the control circuit 520 are similar to the structures of the input circuit 310 and the control circuit 320 described above, which will not be repeated here for the sake of conciseness.

In the embodiment of the present disclosure, the output circuit 530 is also electrically connected to a third power supply VGL2. A third power supply voltage VGL2 is lower than the second power supply voltage VGL1. The control electrode of the second transistor T2 and the control electrode of the fourth transistor T4 in the output circuit 530 include a first control electrode and a second control electrode. The first control electrode and the second control electrode are a top gate of the transistor and a bottom gate of the transistor, respectively. The third power supply voltage VGL2 being lower than the second power supply voltage VGL1 may ensure that threshold voltages Vth of the second transistor T2 and the fourth transistor T4 are positively biased.

A first control electrode of the second transistor T2 is electrically connected to the second node N2, and a second control electrode of the second transistor T2 is electrically connected to the third power supply VGL2. A first control electrode of the fourth transistor T4 is electrically connected to the input terminal INPUT, and a second control electrode of the fourth transistor T4 is electrically connected to the third power supply VGL2.

In the embodiment of the present disclosure, a bottom gate of the second transistor T2 and a bottom gate of the fourth transistor T4 are electrically connected to the third power supply voltage VGL2. Since the third power supply voltage VGL2 applied to the bottom gate is lower than the second power supply voltage VGL1 applied to the top gate, the voltage of the bottom gate is lower than the voltage of the source of the transistor. This results in an increase in the number of positive charges fixed in a semiconductor layer close to the bottom gate, but the charge of the top gate does not change. The increase of charges in the bottom space close to the bottom gate leads to a decrease of movable charges in the channel, and the conductivity level of the transistor decreases, so that the threshold voltages Vth of the second transistor T2 and the fourth transistor T4 are positively biased, preventing the TFT transistor from being unable to be turned off due to a negative bias.

The timing change of each signal of the shift register 500 during the operation process is similar to that of the shift register 300 described above, which will not be repeated for the sake of conciseness.

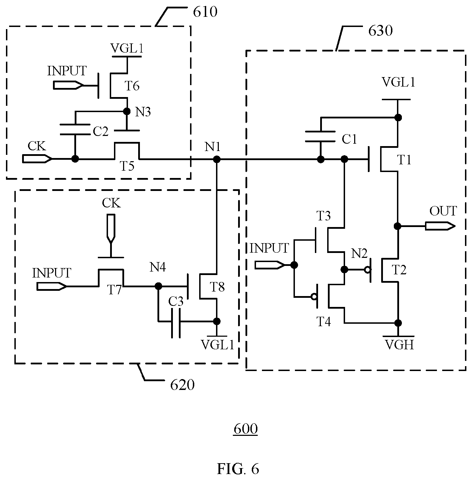

FIG. 6 is a schematic diagram of a structure of a shift register according to another embodiment of the present disclosure.

As shown in FIG. 6, a shift register 600 includes an input circuit 610, a control circuit 620 and an output circuit 630.

Compared with the shift register 300 described above, the second transistor T2 and the transistor T4 are replaced from N-type transistors to P-type transistors in the shift register 600, and the first transistor T1, the third transistor T3, the fifth transistor T5 to the eighth transistor T8 are replaced from P-type transistors to N-type transistors. The voltages output by the input signal INPUT and the clock signal CK become in inversed.

In the embodiment of the present disclosure, the first electrode of the first transistor T1 is electrically connected to the second power supply VGL1. A second electrode of the second transistor T2 is electrically connected to the first power supply VGH. The second electrode of the fourth transistor T4 is electrically connected to the first power supply VGH. The first terminal of the first capacitor C1 is electrically connected to the second power supply VGL1. The first electrode of the sixth transistor T6 is electrically connected to the second power supply VGL1. The second electrode of the eighth transistor T8 is electrically connected to the second power supply VGL1.

Since the types of transistors in the circuits are interchanged between P-type and N-type, the voltages of corresponding input signal INPUT and clock signal CK are completely inversed, so that the operation process of the circuit and the potential of the output signal are similar to those of the shift register 300, which will not be further repeated for the sake of conciseness.

In the embodiment of the present disclosure, the type of the first transistor T1 is different from the type of the second transistor T2. The first transistor T1 is an N-type transistor, which is used to pull down the potential of the output signal. The second transistor T2 is a P-type transistor, which is used to pull up the potential of the output signal.

When the level of the output light-emitting control signal changes inversely, the type of transistor connected to an EM signal in the corresponding pixel circuit is also inverse. In the embodiment of the present disclosure, after the P-type transistor and the N-type transistor are interchanged, the first transistor T1 is used as a pull-down transistor to pull down the output voltage. Since the first transistor T1 is replaced with an N-type transistor, it also has the ability to quickly pull down the potential, the potential of the output signal is more stable. The circuit connection relationship is simple, and the space occupied is small, which is conducive to the narrowing of the display panel frame.

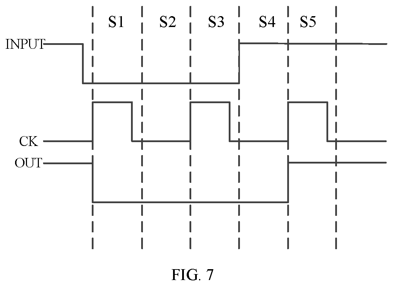

FIG. 7 is a signal timing diagram of a shift register according to another embodiment of the present disclosure.

As shown in FIG. 7, FIG. 7 shows the timing waveforms of each signal at each stage during the operation process of the shift register 600.

The timing waveforms of each signal at each stage during the operation process of the shift register 600 shown in FIG. 7 are inversed with the timing waveforms of each signal at each stage during the operation process of the shift register 300 shown in FIG. 4A.

As shown in FIG. 7, the input signal INPUT is at a low level in the first stage S1 to the third stage S3, and the output signal OUT maintains at a low level in the first stage S1 to the fourth stage S4.

Compared with the shift register 300, the shift register 600 only changes the type of transistors and swaps the connection positions of the first power supply VGH and the second power supply VGL1. Therefore, after the input signal INPUT and the clock signal CK are completely inversed, the potential change of each node in the shift register 600 and the states of the transistors are similar to the timing changes described above, which will not be repeated here for the sake of conciseness.

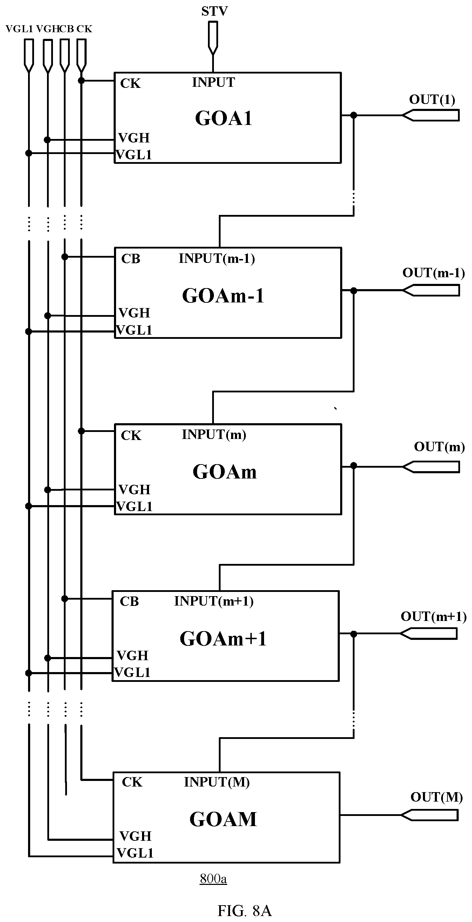

FIG. 8A is a schematic diagram of a structure of a driving circuit according to an embodiment of the present disclosure.

As shown in FIG. 8A, a driving circuit 800a includes M cascaded shift registers, where M is a positive integer greater than 1.

In the embodiment of the present disclosure, the shift register may be any one of the shift register 200, the shift register 300, the shift register 500 and the shift register 600 described above. For example, M shift registers are all shift registers 300. For example, M shift registers are all shift registers 500, which will not be repeated here.

In the embodiment of the present disclosure, among the M cascaded shift registers, an input signal INPUT at an input terminal INPUT of a first shift register GOA1 is a start signal STV, and an input terminal INPUT of an m^{th} shift register is electrically connected to an output terminal OUT(m-1) of an (m-1)^{th} shift register. An input terminal INPUT of an (m+1)^{th} shift register is electrically connected to an output terminal OUT(m) of the m^{th} shift register, where 1<m≤M-1 and m is an integer.

For example, the input terminal INPUT(m) of the m^{th} shift register GOAm is electrically connected to the output terminal OUT(m-1) of the (m-1)^{th} shift register GOAm-1, and the output terminal OUT(m) of the m^{th} shift register GOAm is electrically connected to the input terminal INPUT(m+1) of the (m+1)^{th} shift register GOAm+1.

In the embodiment of the present disclosure, the driving circuit includes a first clock signal line and a second clock signal line. A clock signal CK provided by the first clock signal line and a clock signal CB provided by the second clock signal line are not at effective levels at the same time.

For example, the high level is an effective level. When the clock signal CK is at a high level, the clock signal CB is at a low level. When the clock signal CB is at a high level, the clock signal CK is at a low level.

For example, the low level is an effective level. When the clock signal CK is at a low level, the clock signal CB is at a high level. When the clock signal CB is at a low level, the clock signal CK is at a high level. In the driving circuit 800a, the m^{th} register is electrically connected to the first clock signal line, and the (m+1)^{th} register is electrically connected to the second clock signal line.

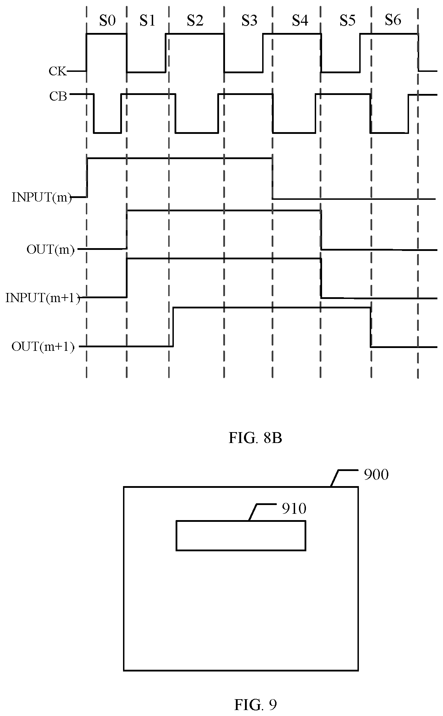

FIG. 8B is a signal timing diagram of a driving circuit according to an embodiment of the present disclosure.

As shown in FIG. 8B, the timing waveform of each signal during the operation process of the m^{th} shift register and the (m+1)^{th} shift register in the driving circuit 800a. The m^{th} shift register and the (m+1)^{th} shift register are the shift register 300 described above.

The m^{th} shift register is electrically connected to the clock terminal CK, and the input signal INPUT(m) is the output signal of the (m-1)^{th} shift register. The (m+1)^{th} shift register is electrically connected to the clock terminal CB, and the input signal INPUT(m+1) is the output signal OUT(m) of the m^{th} shift register.

In the embodiment of the present disclosure, for the shift register 300 described above, the low level is the effective level. When the clock signal CK is at a low level, the clock signal CB is at a high level. When the clock signal CB is at a low level, the clock signal CK is at a high level.

In an S0 stage, INPUT(m) is at a high level. In the S1 stage, the clock signal CK decreases from a high level to a low level, INPUT(m) maintains at a high level, and the output signal OUT(m) of the m^{th} shift register becomes a high level. Since the input signal INPUT(m+1) of the (m+1)^{th} shift register is the output signal OUT(m) of the m^{th} shift register, the input signal INPUT(m+1) of the (m+1)^{th} shift register also becomes a high level at this time.

In the S1 stage to the S5 stage, the waveform changes of each signal during the operation process of the m^{th} shift register are referred to the waveform changes of each signal in the S1 stage to the S5 stage of the shift register 300 described above, which will not be repeated for the sake of conciseness.

In the S2 stage to an S6 stage, the waveform changes of each signal in the (m+1)^{th} shift register during the operation process are described with reference to the waveform changes of each signal in the S1 stage to the S5 stage of the shift register 300 described above, which will not be repeated for the sake of conciseness.

FIG. 9 is a schematic diagram of a structure of a display device according to an embodiment of the present disclosure.

As shown in FIG. 9, a display device 900 may include a driving circuit 910.

In the embodiment of the present disclosure, the driving circuit 910 may be the driving circuit 800 described above, which will not be repeated here.

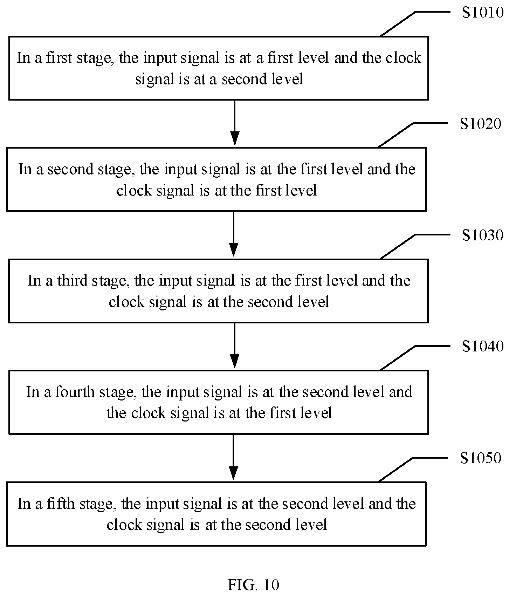

FIG. 10 is a flowchart of a driving method according to an embodiment of the present disclosure.

As shown in FIG. 10, the driving method may include operation S1010 to operation S1050.

In operation S1010, in a first stage, the input signal is at a first level and the clock signal is at a second level.

In operation S1020, in a second stage, the input signal is at the first level and the clock signal is at the first level.

In operation S1030, in a third stage, the input signal is at the first level and the clock signal is at the second level.

In operation S1040, in a fourth stage, the input signal is at the second level and the clock signal is at the first level.

In operation S1050, in a fifth stage, the input signal is at the second level and the clock signal is at the second level.

In the embodiment of the present disclosure, operation S1010 to operation S1050 are similar to the operations performed by the shift register 300 described above, which will not be repeated here.

In the embodiment of the present disclosure, the first stage is similar to the operation of the first stage S1 shown in FIG. 4A. The second stage includes the operation of the second stage S2 shown in FIG. 4A. The third stage is similar to the operation of the third stage S3 shown in FIG. 4A. The fourth stage is similar to the operation of the fourth stage S4 shown in FIG. 4A. The fifth stage is similar to the operation of the fifth stage S5 shown in FIG. 4A. For the sake of conciseness, the same parts of the present disclosure are not repeated here.

In the embodiment of the present disclosure, the first level is at a high level and the second level is at a low level. Those skilled in the art may also set the first level to a low level and set the second level to a high level according to the type of transistor in the shift register.

According to the embodiment of the present disclosure, in the first stage, under control of the first level of the input signal and the second level of the clock signal, the second level of the clock signal is provided to the first node. Under control of the potential of the first node, the first power supply voltage is provided to the output terminal as an output signal.

According to the embodiment of the present disclosure, in the second stage, the potential of the first node is controlled to maintain at a second level under control of the first level of the input signal and the first level of the clock signal. Under control of the potential of the first node, the first power supply voltage is provided to the output terminal as an output signal.

According to the embodiment of the present disclosure, in the third stage, the second level of the clock signal is provided to the first node under control of the first level of the input signal and the second level of the clock signal. Under control of the potential of the first node, the first power supply voltage is provided to the output terminal as an output signal.

According to the embodiment of the present disclosure, in the fourth stage, the potential of the first node is controlled to maintain at the second level under control of the second level of the input signal and the first level of the clock signal. Under control of the potential of the first node, the first power supply voltage is provided to the output terminal as an output signal.

According to the embodiment of the present disclosure, in the fifth stage, the first power supply voltage is provided to the first node under control of the second level of the input signal and the second level of the clock signal. Under control of the potential of the first node, the second power supply voltage is provided to the output terminal as an output signal.

The flowchart and block diagram in the attached figures show the possible architecture, functions, and operations of the system, methods, and computer program products according to various embodiments of the present disclosure. At this time, each box in a flowchart or block diagram may represent a module, program segment, or part of codes that contains one or more executable instructions for implementing the specified logical function. It should also be noted that in some alternative implementations, the functions indicated in the box may also occur in a different order than those indicated in the accompanying drawings. For example, two consecutive boxes may actually be executed in basic parallel, and sometimes they may also be executed in opposite order, which depend on the functionality involved. It should also be noted that each box in the block diagram or flowchart, and the combination of boxes in the block diagram or flowchart, may be implemented using dedicated hardware based systems that perform specified functions or operations, or may be implemented using a combination of dedicated hardware and computer instructions.

Those of skill in the art may understand that the features recorded in the various embodiments and/or claims of the present disclosure may be combined and/or combined in various ways, even if such combinations or combinations are not explicitly recorded in the present disclosure. Specifically, without departing from the spirit and teachings of the present disclosure, the features recorded in the various embodiments and/or claims of the present disclosure may be combined and/or combined in various ways. All these associations and/or combinations fall within the scope of the present disclosure.

The above describes the embodiments of the present disclosure. However, these embodiments are for illustrative purposes only and are not intended to limit the scope of the present disclosure. Although each embodiment has been described separately above, this does not mean that the measures in each embodiment may not be advantageously combined. The scope of the present disclosure is limited by the attached claims and their equivalents. Without departing from the scope of the present disclosure, those of skill in the art may make various substitutions and modifications, all of which should fall within the scope of the present disclosure.

## Claims

1. A shift register, comprising:
an input circuit configured to provide a clock signal from a clock terminal to a first node under control of an input signal from an input terminal;
a control circuit configured to provide a first power supply voltage of a first power supply to the first node under control of the input signal and the clock signal; and
an output circuit configured to provide the first power supply voltage or a second power supply voltage of a second power supply to an output terminal as an output signal under control of a potential of the first node and the input signal.

2. The shift register of claim 1, wherein the output circuit is configured to provide the first power supply voltage or the second power supply voltage of the second power supply to the output terminal as the output signal under control of the potential of the first node and the input signal, comprising:
providing the first power supply voltage to the output terminal as the output signal under control of the potential of the first node; and
providing the second power supply voltage to the output terminal as the output signal under control of the potential of the first node and the input signal.

3. The shift register of claim 1 or 2, wherein the output circuit comprises a first transistor, a second transistor, a third transistor, a fourth transistor and a first capacitor;
wherein a control electrode of the first transistor is electrically connected to the first node, a first electrode of the first transistor is electrically connected to the first power supply, and a second electrode of the first transistor is electrically connected to the output terminal;
wherein a control electrode of the second transistor is electrically connected to a second node, a first electrode of the second transistor is electrically connected to the output terminal, and a second electrode of the second transistor is electrically connected to the second power supply;
wherein a control electrode of the third transistor is electrically connected to the input terminal, and a first electrode of the third transistor is electrically connected to the first node;
wherein a control electrode of the fourth transistor is electrically connected to the input terminal, a first electrode of the fourth transistor is electrically connected to the second node, and a second electrode of the fourth transistor is electrically connected to the second power supply;
wherein a first terminal of the first capacitor is electrically connected to the first power supply, and a second terminal of the first capacitor is electrically connected to the first node.

4. The shift register of claim 3, wherein the first transistor and the second transistor are different types of transistors.

5. The shift register of claim 3,
wherein the control electrode of the second transistor comprises a first control electrode and a second control electrode, the first control electrode of the second transistor is electrically connected to the second node, and the second control electrode of the second transistor is electrically connected to a third power supply;
wherein the control electrode of the fourth transistor comprises a first control electrode and a second control electrode, the first control electrode of the fourth transistor is electrically connected to the input terminal, and the second control electrode of the fourth transistor is electrically connected to the third power supply; and
wherein a third power supply voltage is less than the second power supply voltage.

6. The shift register of claim 1, wherein the input circuit is configured to provide the clock signal from the clock terminal to the first node under control of the input signal from the input terminal, comprising:
providing, when the clock signal switches from a first level to a second level, the second level of the clock signal to the first node, under control of a first level of the input signal.

7. The shift register of claim 1 or 6, wherein the input circuit includes a fifth transistor, a sixth transistor and a second capacitor;
wherein a control electrode of the fifth transistor is electrically connected to a third node, a first electrode of the fifth transistor is electrically connected to the clock terminal, and a second electrode of the fifth transistor is electrically connected to the first node;
wherein a control electrode of the sixth transistor is electrically connected to the input terminal, a first electrode of the sixth transistor is electrically connected to the first power supply, and a second electrode of the sixth transistor is electrically connected to the third node; and
wherein a first terminal of the second capacitor is electrically connected to the third node, and a second terminal of the second capacitor is electrically connected to the clock terminal.

8. The shift register of claim 1, wherein the control circuit is configured to provide the first power supply voltage of the first power supply to the first node under control of the input signal and the clock signal, comprising:
providing the first power supply voltage to the first node, under control of a second level of the clock signal and a second level of the input signal, so as to control the potential of the first node to be at a first level; and
controlling the potential of the first node to maintain at the first level under control of the second level of the clock signal and a first level of the input signal.

9. The shift register of claim 1 or 8, wherein the control circuit comprises a seventh transistor, an eighth transistor and a third capacitor;
wherein a control electrode of the seventh transistor is electrically connected to the clock terminal, a first electrode of the seventh transistor is electrically connected to the input terminal, and a second electrode of the seventh transistor is electrically connected to a fourth node;
wherein a control electrode of the eighth transistor is electrically connected to the fourth node, a first electrode of the eighth transistor is electrically connected to the first node, and a second electrode of the eighth transistor is electrically connected to the first power supply; and
wherein a first terminal of the third capacitor is electrically connected to the fourth node, and a second terminal of the third capacitor is electrically connected to the first power supply.

10. A driving circuit, comprising M cascaded shift registers, wherein an input terminal of an m^{th} shift register is electrically connected to an output terminal of an (m-1)^{th} shift register, 1<m≤M, m is an integer, and M is an integer greater than 1.

11. The driving circuit of claim 10, further comprising:
a first clock signal line and a second clock signal line;
wherein the m^{th} shift register is electrically connected to the first clock signal line, and an (m+1)^{th} shift register is electrically connected to the second clock signal line.

12. A display device, comprising the driving circuit of claim 10 or 11.

13. A driving method applied to the shift register of any one of claims 1 to 9, comprising:
a first stage, in which the input signal is at a first level and the clock signal is at a second level;
a second stage, in which the input signal is at the first level and the clock signal is at the first level;
a third stage, in which the input signal is at the first level and the clock signal is at the second level;
a fourth stage, in which the input signal is at the second level and the clock signal is at the first level; and
a fifth stage, in which the input signal is at the second level and the clock signal is at the second level.

14. The driving method of claim 13, further comprising:
in the first stage, providing the second level of the clock signal to the first node, under control of the first level of the input signal and the second level of the clock signal; and
providing the first power supply voltage to an output terminal as an output signal under control of a potential of the first node.

15. The driving method of claim 13, further comprising:
in the second stage, controlling a potential of the first node to maintain at the second level under control of the first level of the input signal and the first level of the clock signal; and
providing the first power supply voltage to an output terminal as an output signal under control of the potential of the first node.

16. The driving method of claim 13, further comprising:
in the third stage, providing the second level of the clock signal to the first node under control of the first level of the input signal and the second level of the clock signal; and
providing the first power supply voltage to an output terminal as an output signal under control of a potential of the first node.

17. The driving method of claim 13, further comprising:
in the fourth stage, controlling a potential of the first node to maintain at the second level under control of the second level of the input signal and the first level of the clock signal; and
providing the first power supply voltage to an output terminal as an output signal under control of the potential of the first node.

18. The driving method of claim 13, further comprising:
in the fifth stage, providing the first power supply voltage to the first node under control of the second level of the input signal and the second level of the clock signal; and
providing the second power supply voltage to an output terminal as an output signal under control of a potential of the first node.
